# EUROPEAN PATENT APPLICATION

(11) **EP 1 658 977 A1**
(43) Date of publication of application: **24.05.2006**
(21) Application number: 04772193.1
(22) Date of filing: 19.08.2004
(51) Int. Cl.: B41J 2/05, H01L 27/06

(54) **LIQUID DISCHARGE HEAD, LIQUID DISCHARGE DEVICE, AND METHOD FOR MANUFACTURING LIQUID DISCHARGE HEAD**

(30) Priority: 28.08.2003 JP 2003303853
(71) Applicant: SONY CORPORATION, Tokyo 141-0001 (JP)
(72) Inventor: MIYAMOTO, Takaaki, Shinagawa-ku, Tokyo 1410001 (JP); KOHNO, Minoru, Shinagawa-ku, Tokyo 1410001 (JP); TATEISHI, Osamu, Fukuoka-shi, Fukuoka 8140001 (JP)
(74) Representative: Müller, Frithjof E.
(86) International application number: PCT/JP2004/012237
(87) International publication number: WO 2005/021267

(57) **Abstract**

The present invention relates to a liquid delivery head, a liquid delivery device, and a process for production of the liquid delivery head, which are applicable to ink-jet printers of thermal type in which heating elements and transistors to drive them are integrally formed on the same substrate. The transistors are metal oxide field effect transistors which have a polycide gate or metal gate for reduction in parasitic resistance.

## Description

### Technical Field

The present invention relates to a liquid delivery head, a liquid delivery device, and a process for production of the liquid delivery head, which are applicable to ink-jet printers of thermal type in which heating elements and transistors to drive them are integrally formed on the same substrate. The transistors are metal oxide field effect transistors which have a polycide gate or metal gate for reduction in parasitic resistance.

### Background Art

There is an increasing demand for color hard copies in the field of image processing. This demand has been met by several color copying processes, which include dye sublimation thermal transfer process, melting thermal transfer process, ink jet process, electrophotography process, and thermal development silver salt process.

Of these processes, the ink jet process is simple in constitution and yet capable of producing high-quality images. It is so designed as to eject ink droplets toward printing paper (or any other objects) from nozzles that open in the printer head (or liquid delivery head). The ink jet processes are classified into three categories, electrostatic pulling process, continuously vibrating process (or piezo process), and thermal process, according to the method by which ink droplets are ejected from nozzles.

The thermal process is so designed as to generate bubbles by local ink heating, thereby causing the bubbles to eject ink from nozzles toward printing paper. Thus it is capable of printing color images despite its simple structure.

The printer head of thermal process has the heating elements to heat ink which are formed on the same semiconductor substrate integrally with the logic integrated circuits to drive the heating elements. In the printer head of this type, the heating elements are densely arranged so that they drive certainly.

In other words, the printer head of thermal process is required to have densely arranged heating elements for high-quality printing. To be concrete, it is necessary that the heating elements be arranged at intervals of 42.333 µm for print quality corresponding to 600 DPI. Unfortunately, it is very difficult to arrange driving elements individually for the densely arranged heating elements. The printer head that avoids such difficulties has switching transistors and heating elements on the same semiconductor substrate, with the former being connected to the latter by the integrated circuit technology. The switching transistors are driven by driving circuits formed on the same semiconductor substrate. In this way the individual heating elements are driven easily and certainly.

In the printer head, the switching transistors and the driving circuits to drive them are MOS (Metal Oxide Semiconductor) field effect transistors (metal oxide field effect transistors), and the heating elements are made of tantalum (Ta), tantalum nitride (TaNₓ), or tantalum aluminum (TaAl).

Each heating element receives a pulse voltage to evolve 0.8 to 1.4 µJ of heat, which generates bubbles in the ink chamber, thereby ejecting ink droplets from nozzles. Although the driving circuit is constructed of MOS transistors which usually operate at 5 V, the switching transistors to drive the heating elements under control of the driving circuit operate at a source voltage of 8 to 25 V, so that the heating elements are supplied with sufficient electric power. This is because the electric power applied to the heating element is proportional to voltage squared and inversely proportional to resistance.

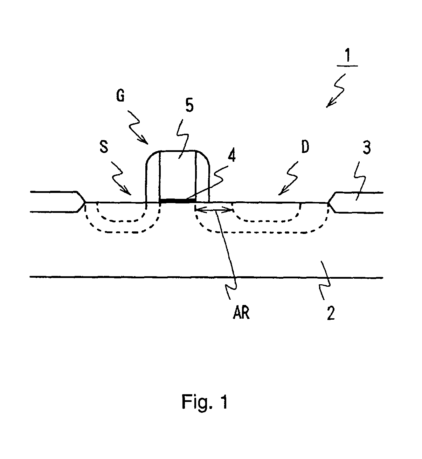

Fig. 1 is a sectional view showing the constitution of the switching transistor of this kind. The transistor 1 is made up of a silicon substrate 2, a LOCOS (Local Oxidation of Silicon) 3 of silicon nitride (Si₃N₄), a gate oxide film 4 in the transistor forming region, and a gate G of polysilicon 5 in laminate structure. In other words, the transistor of this kind has a gate of polysilicon electrode. In addition, the transistor of this kind has a source S and drain D which are formed on the silicon substrate 2 by ion implantation and heat treatment. The transistor 1 constructed in this manner has a low-concentration diffusion layer AR between the gate G and the drain D. This diffusion layer AR relieves the electric field between the drain and the channel forming region under the gate, thereby increasing the breakdown voltage.

A printer head disclosed in Japanese Patent Laid-open No. Hei 10-138484 is provided with transistors each having a 3 µm long polysilicon gate. This gate length is the lower limit that can be achieved by using a mirror projection aligner (MPA), which is a 1:1 exposure system.

On the other hand, a printer head of side shoot type is proposed in Japanese Patent Laid-open No. 2000-1083555. This printer head has the heating elements and gates which are formed simultaneously from polysilicon. The printer head of side shoot type is characterized in that the nozzle is not positioned right above the heating element, so that the heating element generates bubbles and the resulting bubbles transmit pressure waves to eject ink droplets from the nozzle.

The transistor to drive the heating element, which ejects ink droplets, consumes electric power in varying amounts depending on the on-resistance of the transistor and the resistance of the wiring pattern (which are collectively referred to as parasitic resistance). Since the transistor is serially connected to the heating element, the driving voltage applied by the transistor is divided by the parasitic resistance and the resistance of the heating element. Therefore, the parasitic resistance should be much smaller than the resistance of the heating element if the heating element is to be driven efficiently.

Thus it is considered that if the parasitic resistance is reduced, then it would be possible to realize a printer which consumes less electric power than before and ejects ink droplets much more efficiently. It is also considered that the decreased parasitic resistance will reduce voltage to drive the heating element.

### Disclosure of Invention

The present invention was completed in view of the foregoing. It is an object of the present invention to provide a liquid delivery head with a reduced parasitic resistance, a liquid delivery device, and a process for production of the liquid delivery head.

In order to attain the above object, according to the present invention, there is provided a liquid delivery head having heating elements and metal oxide field effect transistors to drive them which are formed on a substrate such that the heating elements driven by the metal oxide field effect transistors heat a liquid contained in a liquid chamber, thereby ejecting the liquid in the form of droplets from nozzles, each of the metal oxide field effect transistors can have a polycide gate or a metal gate.

In the configuration of the present invention, there is provided a liquid delivery head having heating elements and metal oxide field effect transistors to drive them which are formed on a substrate such that the heating elements driven by the metal oxide field effect transistors heat a liquid contained in a liquid chamber, thereby ejecting the liquid in the form of droplets from nozzles, the depletion layer between the polycide gate or metal gate and the gate oxide film can be thinner than that between the conventional polysilicon gate and the gate oxide film. The thin depletion layer increases drain current and decreases on-resistance and parasitic resistance.

According to the present invention, a liquid delivery device for ejecting liquid droplets toward an object from a liquid delivery head, characterized in that the liquid delivery head has heating elements and metal oxide field effect transistors to drive them which are formed on a substrate such that the heating elements driven by the metal oxide field effect transistors heat a liquid contained in a liquid chamber thereby ejecting the liquid in the form of droplets from nozzles, and each of the metal oxide field effect transistors has a polycide gate or a metal gate.

Accordingly, the liquid delivery device can have a lower parasitic resistance than before.

In addition, according to the present invention, there is provided a process for production of a liquid delivery head which has heating elements and metal oxide field effect transistors to drive them which are formed on a substrate such that the heating elements driven by the metal oxide field effect transistors heat a liquid contained in a liquid chamber, thereby ejecting the liquid in the form of droplets from nozzles, each of the metal oxide field effect transistors can have a polycide gate or a metal gate.

The process according to the present invention is designed to form the polycide gate or metal gate for the metal oxide field effect transistor to drive the heating element. The resulting transistor can have a lower parasitic resistance than before.

### Brief Description of the Drawings

Fig. 1 is a sectional view showing the transistor which is applied to the conventional printer head.
Fig. 2 is a perspective view showing the printer pertaining to the first embodiment of the present invention.
Fig. 3 is a plan view showing the arrangement of head chips in the printer shown in Fig. 2.
Fig. 4 is a sectional view showing the printer head which is applied to the printer shown in Fig. 2.
Figs. 5(A) and 5(B) are sectional views illustrating the steps of preparing the printer head shown in Fig. 4.
Figs. 6(A) and 6(B) are sectional views illustrating the steps that follow the step shown in Fig. 5(B).
Figs. 7(A) and 7(B) are sectional views illustrating the steps that follow the step shown in Fig. 6(B).
Fig. 8 is a sectional view showing the transistor which is produced by the steps shown in Fig. 5.
Fig. 9 is a sectional view of the transistor which is applied to the printer head incorporated into the printer pertaining to second embodiment of the present invention.

### Best Mode for Carrying out the Invention

Embodiments of the present invention will be described in more detail with reference to the accompanying drawings.

### (1) Configuration of Embodiment

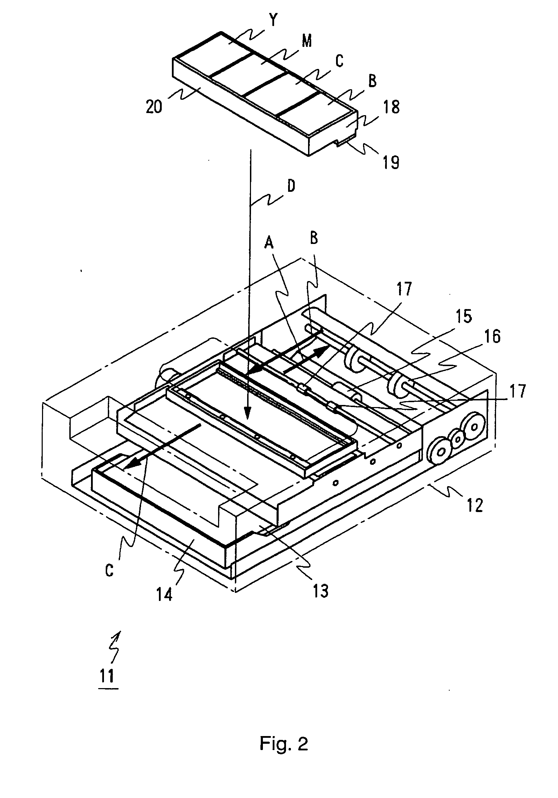

Fig. 2 is a perspective view that shows a printer pertaining to the present invention. A line printer 11 is entirely housed in a rectangular enclosure 12. The line printer 11 is provided with a paper tray 14 that holds paper 13 on which images are to be printed. For paper feeding, the paper tray 14 is inserted into the paper tray port at the front of the enclosure.

Once the line printer 11 is provided with the paper tray 14 through the paper tray port, the paper 13 is pressed against the paper feed roller 15 by a paper feed mechanism. The paper feed roller 15 turns to feed the paper 13 in the direction of arrow A toward the rear side of the line printer 11. The direction of paper feed is reversed by the reverse roller 16 placed near the rear side of the line printer 11. Thus, the reverse roller 16 moves back the paper 13 in the direction of arrow B toward the front side of the line printer 11.

Then, the paper 13 is further transported over the paper tray 14 in the direction of arrow C by spur rollers 17 and finally discharged from the paper discharge port at the front side of the line printer 11. The line printer 11 has the exchangeable head cartridge 18 indicated by arrow D between the spur rollers 17 and the paper discharge port.

The head cartridge 18 consists of a holder 20 and exchangeable ink cartridges contained therein for yellow (Y), magenta (M), cyan (C), and black (B) inks. The ink cartridges are connected to their respective printer heads 19 attached to the lower surface of the holder 20. Being constructed in this manner, the line printer 11 is capable of printing images on the printing paper 13 with inks of different color supplied from the line head.

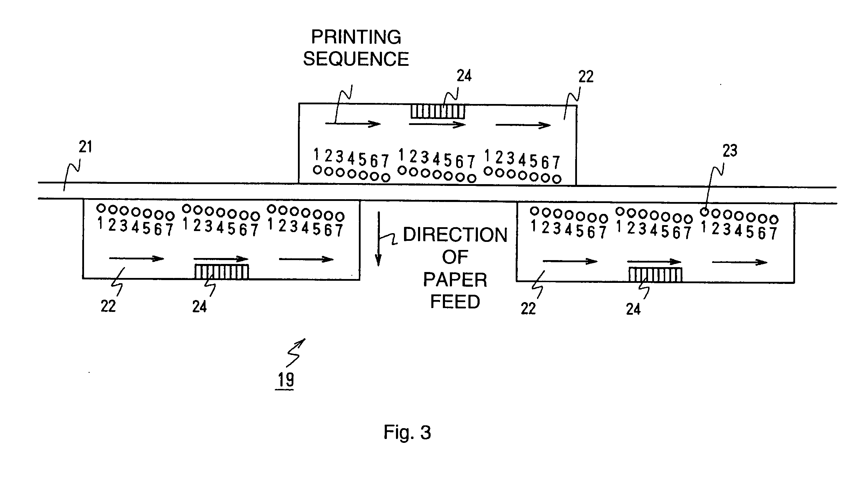

Fig. 3 is a partly enlarged plan view showing the printer head 19 as viewed from the printing paper 13 shown in Fig. 2. The printer head 19 consists of the ink duct 21 for each ink and the head chips 22 of identical structure which are arranged zigzag (along both sides of the ink duct 21) on the nozzle plate. Each head chip 22 is positioned such that the heating element therein is close to the ink duct 21. In other words, the head chips 22 are symmetrical to each other with respect to the ink duct. Thus, the printer head 19 can supply ink to the head chip 22 through a single ink duct 21 for each color. This simple structure contributes to precision printing with a high resolution.

The head chip 22 has the connecting pad 24 at the center of its length in which nozzles 23 (or minute ink delivery ports) are arranged. Positioning the connecting pad 24 in this manner prevents one flexible wiring board connected to one connecting pad 24 from coming close to the other flexible wiring board connected to the other adjacent connecting pad 24.

A problem that arises when the position of the nozzle 23 is shifted as mentioned above is that it is necessary to reverse the sequence of driving signals for the heating elements in the head chips 22 placed above and below the ink duct 21. However, this problem is avoided because the head chip 22 is so constructed as to adequately switch the drive sequence in the driving circuit.

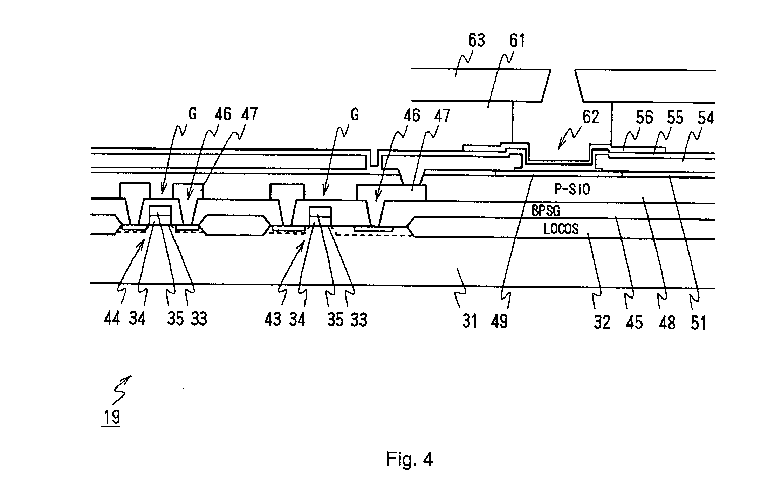

Fig. 4 is a sectional view showing the printer head to be used for the printer. The printer head 19 consists of a silicon substrate (wafer), drive circuits, heating elements, and ink chambers. The procedure for fabrication is as follows.

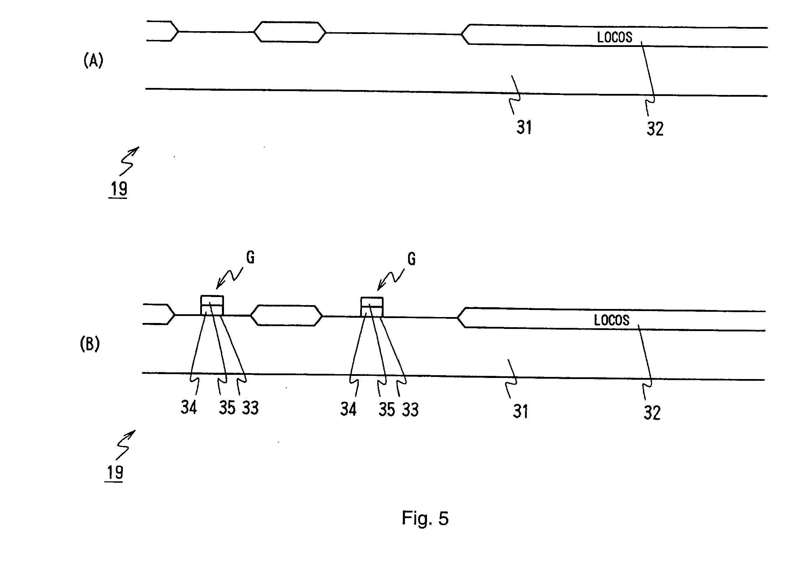

First, a cleaned silicon substrate (wafer) 31 is coated with silicon nitride film (Si₃N₄) by deposition, as shown in Fig. 5(A). Then, lithography and reactive ion etching are performed on the coated silicon substrate 31 for its removal excluding the region where transistors are to be formed. Thus the silicon nitride film on the silicon substrate 31 remains only in the region for transistors.

Next, thermal silicon oxide film (500 nm thick) is formed by thermal oxidation in the region where the silicon nitride film has been removed. This thermal silicon oxide film form the element isolating region 32 or LOCOS (local oxidation of silicon) to separate transistors from each other. Incidentally, the thickness of the element isolating region 32 eventually swells to 260 nm after ensuing steps.

The silicon substrate 31 is cleaned and then a thermal oxide film for the gate is formed in the transistor forming region, as shown in Fig. 5(B). After further cleaning, a polysilicon film (100 nm thick) is formed by CVD (chemical vapor deposition) process. Next, a tungsten silicide (WSi₂) film (100 nm thick) is formed from a gas composed of WF₆ + SiH₄ or WF₆ + SiH₂Cl₂ by CVD process. Incidentally, the tungsten silicide film may be formed by sputtering. The gate region is exposed by lithography, and then dry etching with a mixed gas of SF₆ + HBr is carried out to remove the unnecessary thermal oxide film, polysilicon film, and tungsten silicide film. In this way there is obtained the electrode for the gate G which is composed of the gate oxide film 33, the polysilicon film 34, and the tungsten silicide film 35.

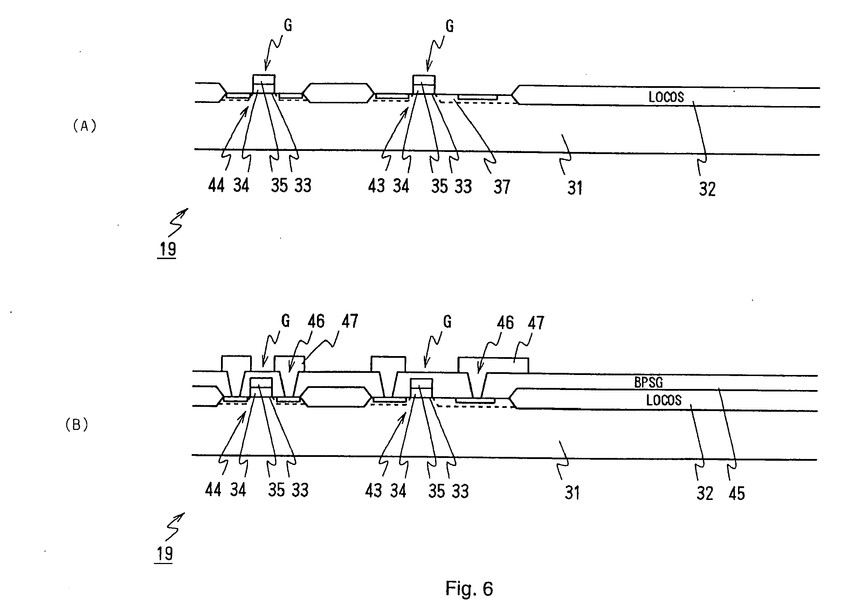

In the subsequent steps shown in Fig. 6(A), the silicon substrate 31 undergoes ion implantation and heat treatment so that the low-concentration diffusion layer 37 is formed, and the silicon substrate 31 further undergoes ion implantation and heat treatment so that the source-drain region is formed. In this way there is obtained the MOS transistors 43 and 44. Incidentally, the low-concentration diffusion layer 37 is a field limiting layer to ensure the source-drain insulation resistance. The switching transistor 43 functions as a MOS driver transistor having a dielectric strength of about 18 to 25 V to drive the heating element, and the switching transistor 44 functions as a transistor (which works at 5 V) as a constituent of the integrated circuit to control the driver transistor 43.

In this embodiment, the MOS transistors with the polycide gate are produced by lithography with a stepper of step-and-repeat type having a reduction ratio of 1/4 or 1/5, in which the light source for exposure is g-line (ultraviolet rays) having a wavelength of 436 nm. Owing to this procedure, the resulting transistors 43 and 44 have a smaller gate than that produced by the conventional exposure system having a reduction ratio of 1/1. To be concrete, the transistors 43 and 44 in this embodiment have a gate length shorter than 2 µm.

Owing to the short polycide gate, the transistor 44 in this embodiment has a low on-resistance and hence has a low parasitic resistance accordingly. The low resistance leads to the efficient driving of the heating element. Incidentally, in this embodiment, the reduction exposure with g-line is employed in lithography for other steps than the steps for the transistors 43 and 44.

In the next step, CVD is carried out, as shown in Fig. 6(B), to sequentially form a PSG film (100 nm thick) and a BPSG film (500 nm thick). The PSG (Phosphorus Silicate Glass) film is a phosphorus-doped silicon oxide film, and the BPSG (Boron Phosphorus Silicate Glass) film is a boron- and phosphorus-doped silicon oxide film. These two films constitute the first interlayer dielectric film 45 (600 nm thick).

In the next step subsequent to photolithography, the contact holes 46 are formed on the silicon semiconductor diffusion layer (source-drain) by reactive ion etching with a mixed gas of C₄F₈/CO/O₂/Ar.

The foregoing step is followed by cleaning with dilute hydrofluoric acid. Then, sputtering is performed to form the wiring pattern layer which is composed of the following five films sequentially formed on top of the other.
Titanium film, 30 nm thick.
Titanium nitride-oxide barrier metal film, 70 nm thick. Titanium film, 30 nm thick.
Aluminum film containing 1 at% silicon or 0.5 at% copper, 500 nm thick. Titanium nitride-oxide (TiON) film, 25 nm thick, as an anti-reflection coating film.

The thus formed wiring pattern layer is selectively removed by photolithography and dry etching. Thus the wiring pattern 47 for the first layer is formed. This wiring pattern 47 constitutes the logic integrated circuit that connects the MOS transistor 44 for the driving circuit.

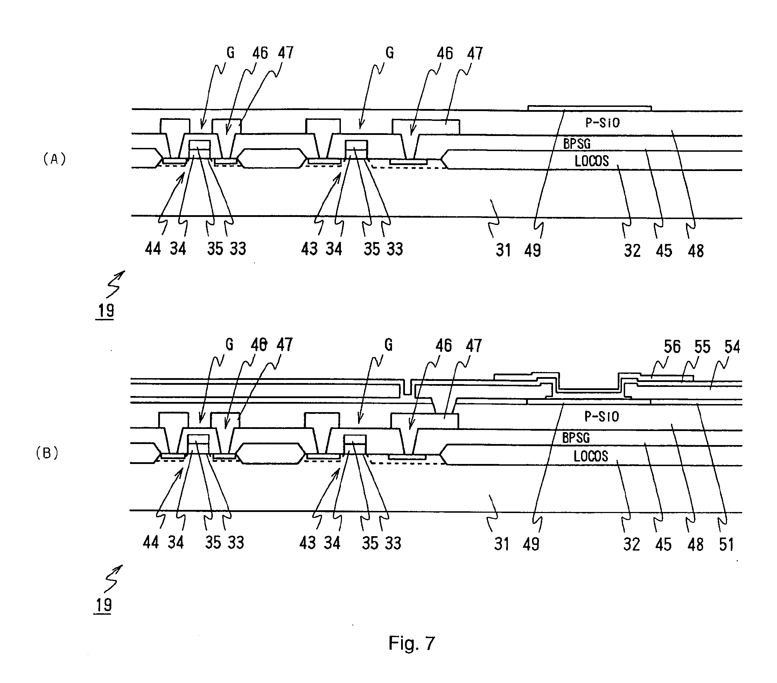

Then, CVD process with TEOS (tetraethoxysilane) Si(OC₂H₅)₄ gas is performed to deposit the silicon oxide film as an interlayer dielectric film, as shown in Fig. 7(A). The silicon oxide film is covered with a coating silicon oxide film by SOG (spin on glass). The silicon oxide film is planarized by back etching. This step is repeated twice. Thus there is obtained the second interlayer dielectric film 48 of silicon oxide film (440 nm thick) which insulates the wiring pattern in the second layer adjacent to the wiring pattern 47 in the first layer.

Next, sputtering is performed under the following conditions to deposit a β-tantalum film (50 to 100 nm thick) which functions as a resistance film.
Wafer temperature: 200 to 400°C
DC power applied: 2 to 4 kW
Argon gas flow rate: 20 to 40 sccm
The resistance film is patterned by photolithography and dry etching with BCl₃/Cl₂ gas to form the heating element 49 having a resistance of 4 to 100 Ω.

The entire surface is covered with a silicon nitride film (300 nm thick) by CVD process. This silicon nitride film functions as the insulation protective film 51 for the heating element 49. The silicon nitride film is selectively removed by photolithography and dry etching with a mixed gas of CHF₃/CF₄/Ar, so that the heating element 49 is partly exposed for connection to the wiring pattern. Additional dry etching with a mixed gas of CHF₃/CF₄/Ar is performed to make the via hole 52 in the interlayer dielectric film 48. The steps up to this stage are shown in Fig. 7(B).

The foregoing step is followed by sputtering that sequentially forms a titanium film (200 nm thick), an aluminum film (600 nm thick) containing 1 at% silicon or 0.5 at% copper, a titanium nitride oxide film (25 nm thick) as an anti-reflection film, and a wiring pattern layer of silicon- or copper-containing aluminum.

In the subsequent step, the wiring pattern layer is selectively removed by photolithography and dry etching with a mixed gas of BCl₃/Cl₂. Thus there is obtained the second layer of wiring pattern 54. This wiring pattern is for power supply and grounding and also for connection of the driver transistor 44 to the heating element 49. Incidentally, the silicon nitride film 51 remaining on the heating element 49 functions as a protective layer which protects the heating element 49 from etching that is performed to form the wiring pattern. During etching, the silicon nitride film 51 decreases in thickness from 300 nm to 100 nm.

Next, plasma CVD is performed to deposit the silicon nitride film 55 (400 nm thick), which functions as an ink protective layer and an insulating layer. This step is followed by heat treatment at 400°C for 60 minutes in an atmosphere of nitrogen gas (which may contain 4% hydrogen). This heat treatment makes the transistors 43 and 44 work stably and reduces contact resistance between the first layer of wring pattern 47 and the second layer of wiring pattern 54.

On the silicon nitride film 55 is deposited a layer of β-tantalum (100 to 300 nm thick) by DC magnetron sputtering that employs tantalum as the target. This layer is patterned into the anti-cavitation layer 56 by dry etching with BCl₃/Cl₂ gas. Incidentally, the anti-cavitation layer 56 absorbs physical shocks due to cavitation which takes place when bubbles disappear after they have been generated in the ink chamber by the heating element 49. Thus it protects the heating element 49 from physical damage as well as chemical action of ink heated to high temperatures by the heating element 49. The above-mentioned β-tantalum may be replaced by tantalum aluminum (TaAl) containing about 15 at% aluminum. As compared with the β-tantalum film, the TaAl film has a less compressive stress because of its structure with aluminum existing in the crystal boundary of β-tantalum.

After fabrication mentioned above, as shown in Fig. 4, the substrate is covered with a dry film 61 of organic resin by contact bonding. Those parts corresponding to the ink chamber 62 and the ink duct are removed from the dry film 61, and then the remaining parts of the dry film 61 are cured. In this way the ink chamber 62 and the ink duct are formed. The thus fabricated substrate is scribed into pieces to be made into head chips 22. To the dry film 61 on each piece is bonded the nozzle plate 63, which is a preformed sheet member that provides the nozzle 23 above the heating element 49. In this way the printer head 19 is completed which has the nozzle 23, the ink chamber 62, and the ink duct 21 through which ink is introduced into the ink chamber 62. The printer head 19 is formed in such a way that the ink chambers 62 form a continuous line in the paper feed direction. The assembly of such printer heads constitute the line head.

### (2) Operation of Embodiment

The printer head 19 fabricated as mentioned above is composed of the following components formed on the silicon substrate 31. Metal oxide field effect transistors 43 and 44 with isolation dielectrics 32.

The first layer of wiring pattern 47 insulated by the insulating layer 45. (It is connected to the transistor 47 and the transistor 44.)
The transistor 47 to drive the heating element 49.
The transistor 44 to constitute the logic circuit.
The heating element 49.
The insulating protective layer 51.
The second layer of wiring pattern 54, which connects the transistor 43 to the heating element 49 and which leads to power source and ground.
The anti-cavitation layer 56, the ink chamber 62, and the nozzle 23. (Figs. 4 to 7)

The printer head 19 works as follows. The ink chamber 62 is supplied with ink contained in the head cartridge 18 through the ink duct 21, as shown in Fig. 3. The ink introduced into the ink chamber 62 is heated by the heating element 49. This heating generate bubbles, which in turn rapidly increases the pressure in the ink chamber 62. The increased pressure causes the ink to fly (in the form of ink droplets) from the nozzles 23. The ink droplets attach themselves to the printing paper 13 which has been fed from the paper tray 14 by the rollers 15, 16, and 17, as shown in Fig. 2.

A problem with the line printer 11 that performs printing as mentioned above is that the heating element 49 does not work efficiently if there is a high parasitic resistance ascribing to on-resistance of the transistor 43 and resistance of the wiring pattern 54. In other words, the high parasitic resistance consumes a large amount of electric power to be supplied to drive the heating element 49.

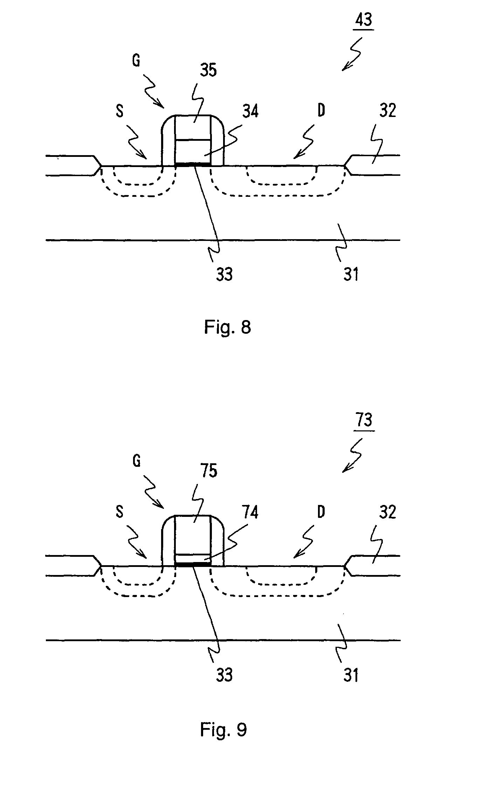

In the present invention, this problem is solved in the following manner. The heating element 49 is driven by the transistor 43 in which the gate is the tungsten silicide film 35, as shown in Fig. 8. The polycide gate has a lower on-resistance than the conventional polysilicon gate. This leads to reduction in parasitic resistance, which in turn permits the heating element 49 to work efficiently.

Another component of the parasitic resistance is the on-resistance of the transistor 43. In the case of metal oxide field effect transistor, it is possible to reduce the on-resistance by making the gate oxide film thinner, thereby increasing the drain-source current which is inversely proportional to (gate length) x (gate oxide film thickness). However, this principle is not applicable to the conventional polysilicon gate, in which the depletion layer (due to disappearance of free electrons) is liable to occur in the interface between the gate oxide film and the electrode. This depletion layer apparently increases the thickness of the gate oxide film and hence prevents the drain-source current from increasing sufficiently.

On the other hand, it is possible to reduce the thickness of the depletion layer by reducing the resistance of the gate. In fact, the gate of tungsten silicide film 35 in this embodiment has a resistance which is approximately one-tenth that of the conventional polysilicon gate. Thus the advantage of the printer head 19 in this embodiment is that the depletion layer between the gate oxide film and the electrode can be made thinner than that in the case of the polysilicon gate. The result is an increased drain current, a reduced on-resistance, and efficient driving of the heating element 49.

The printer head 19 in this embodiment is also characterized in its fabrication process. The lithography step to form the transistor 43 employs the stepper of step-and-repeat type designed for exposure with g-line (ultraviolet rays) having a wavelength 436 nm. This stepper operates with a reduction ratio of 1/4 or 1/5. The advantage of this stepper over the conventional mirror projection aligner (with a 1:1 ratio) is its ability to significantly reduce the feature size. In fact, when fabricated by using this stepper, the resulting transistor 49 to drive the heating element 49 has the gate length as short as 2 µm. This short gate length leads to a lower on-resistance and efficient driving of the heating element 49.

The actual measurement of the transistor 43 having the gate length of 2 µm revealed that the resistance of the heating element 49 is 100 Ω while the parasitic resistance is about 11 Ω (which is equivalent to the on-resistance of 10 Ω of the transistor 43). This result explains why the heating element 49 can be driven efficiently. By contrast, a transistor with a polysilicon gate, 3 µm long, produces an on-resistance of 17 Ω.

### (3) Effect of the Embodiment

The printer head constituted as mentioned above has a lower parasitic resistance than the conventional one, because its metal oxide field effect transistor to drive the heating element has the polycide gate. The low parasitic resistance permits the efficient driving of the heating element.

Moreover, the low parasitic resistance is also due to the gate with a gate length smaller than 2 µm. It contributes to the efficient driving of the heating element.

### (4) Second Embodiment

Fig. 9 is a sectional view showing the transistor 73 used for the printer head of the printer pertaining to second embodiment of the present invention. This transistor is identical with that shown in Fig. 8 (used for the printer head 19 in the first embodiment) except for the gate structure.

The gate in this transistor 73 is a metal gate of laminate structure which is composed of a gate oxide film 33, a tungsten nitride film 74, and a tungsten film 75. The tungsten used for this metal gate has a resistance which is about one-hundredth that of polysilicon. The gate for this transistor 73 is formed by sequentially depositing the gate oxide film 33, the tungsten nitride film (5 nm thick) by sputtering, and the tungsten film (100 nm thick) by sputtering, and finally patterning these deposited films.

As mentioned above, it is possible to produce the same effect as in the first embodiment by replacing the polycide gate with the metal gate. The gate having a lower resistance further contributes to the reduction of on-resistance.

### (5) Additional Embodiment

The embodiments mentioned above are concerned with the transistor to drive the heating element which is fabricated by lithography with the stepper that employs g-line for exposure. The present invention is not limited to using such a stepper. Other usable steppers include one which employs i-line having a wavelength of 365 nm, one which employs KrF excimer laser having a wavelength of 248 nm, and one which employs ArF excimer layer having a wavelength of 193 nm.

The embodiments mentioned above are concerned with the printer head to deliver ink droplets. However, the present invention is not limited to such a printer head. It may be applied to any liquid delivery head for various kinds of liquids other than ink, such as dye solutions and protective film forming solutions. It may also be applied to microdispensers (which handle reagents in the form of droplets), measuring devices, testing machines, and patterning apparatuses (which handle droplets of chemicals for protection from etching).

### Industrial Applicability

The present invention, which relates to a liquid delivery head, a liquid delivery device, and a process for production of the liquid delivery head, may be applied to the ink-jet printer of thermal type in which the heating elements and the transistors to drive them are integrally formed on the same substrate.

## Claims

1. A liquid delivery head having heating elements and metal oxide field effect transistors to drive said heating elements which are formed on a substrate such that said heating elements driven by said metal oxide field effect transistors heat a liquid contained in a liquid chamber, thereby ejecting said liquid in the form of droplets from nozzles, **characterized in that** each of said metal oxide field effect transistors has a polycide gate or a metal gate.

2. The liquid delivery head as defined in Claim 1, wherein the gate has a gate length no larger than 2 µm.

3. A liquid delivery device for ejecting liquid droplets toward an object from a liquid delivery head, **characterized in that** said liquid delivery head has heating elements and metal oxide field effect transistors to drive said heating elements which are formed on a substrate such that said heating elements driven by said metal oxide field effect transistors heat a liquid contained in a liquid chamber, thereby ejecting said liquid in the form of droplets from nozzles, and each of said metal oxide field effect transistors has a polycide gate or a metal gate.

4. A process for production of a liquid delivery head which has heating elements and metal oxide field effect transistors to drive said heating elements which are formed on a substrate such that said heating elements driven by said metal oxide field effect transistors heat a liquid contained in a liquid chamber, thereby ejecting said liquid in the form of droplets from nozzles, **characterized in that** each of said metal oxide field effect transistors has a polycide gate or a metal gate.
